# EUROPEAN PATENT SPECIFICATION

(11) **EP 4 489 069 B1**
(45) Date of publication and mention of the grant of the patent: **03.12.2025**
(21) Application number: 24185644.2
(22) Date of filing: 01.07.2024
(51) Int. Cl.: H01L 23/473, H01L 23/367

(54) **COOLING SYSTEM FOR A POWER MODULE AND POWER MODULE PROVIDED WITH SAID COOLING SYSTEM**
KÜHLSYSTEM FÜR EIN LEISTUNGSMODUL UND LEISTUNGSMODUL MIT DIESEM KÜHLSYSTEM
SYSTÈME DE REFROIDISSEMENT POUR UN MODULE DE PUISSANCE ET MODULE DE PUISSANCE POURVU DUDIT SYSTÈME DE REFROIDISSEMENT

(30) Priority: 06.07.2023 IT 202300014145
(43) Date of publication of application: 08.01.2025
(73) Proprietor: Marelli Europe S.p.A., 20011 Corbetta (MI) (IT)
(72) Inventor: FRANCESCONI, Gianluca, 20011 Corbetta (MI) (IT)
(74) Representative: Novagraaf Group

(56) References cited:
- WO-A1-2023/273689
- US-A1- 2009 145 581
- US-A1- 2010 091 457
- US-A1- 2010 172 091
- US-A1- 2012 175 094
- US-A1- 2018 024 599

## Description

### CROSS-REFERENCE TO RELATED APPLICATIONS

This patent application claims priority from Italian patent application no. 102023000014145 filed on July 6, 2023.

### TECHNICAL FIELD

The invention relates to a cooling system for a power module and to a power module provided with said cooling system.

In particular, the invention can advantageously be applied to the cooling of the circuits and of the components of the power module.

### PRIOR ART

Power modules are widely used. One of their possible uses is, for example, in the inverters of electric vehicles. During their use, however, they generate heat that must be disposed of, namely dissipated. To this regard, known power modules typically have dissipation means (such as, for example, fins or pins, which project into a path of the cooling fluid defined between an inlet and an outlet of the path itself). The dissipation means are hit, i.e. lapped, by the cooling fluid (typically water, like for example in US2012175094A1, or air) and dissipate (i.e. dispose of) the heat produced.

However, it has been found that known dissipation means are not capable of an adequate cooling as the powers increase. In particular, it was found that, as the power ranges increase, the sections closest to the outlet of the cooling path are subject to a lower cooling than the sections arranged upstream thereof, thus leaving the circuits and the components of the power module subject to high temperatures. In particular, it has been found that, in known power modules, the difference in temperature between a cooled section close to the inlet and a cooled section closer to the outlet can be greater than 10°C. Therefore, an uneven cooling leads to a non-optimal operation of the components of the power module and, hence, of the power module itself.

### DESCRIPTION OF THE INVENTION

The object of the invention is to provide a cooling system for a power module, which does not suffer from the drawbacks described above and, in particular, is easy and economic to be manufactured.

A further object of the invention is to provide a power module provided with said cooling system, which does not suffer from the drawbacks described above and, in particular, is easy and economic to be manufactured.

According to the invention, there are provided cooling system for a power module and a power module provided with said cooling system as claimed in the appended claims. The appended claims describe preferred embodiments of the invention and form an integral part of the description.

### BRIEF DESCRIPTION OF THE DRAWINGS

The invention will now be described with reference to the accompanying drawings showing a non-limiting embodiment thereof, wherein:
- figure 1 is a schematic plan view (with some parts removed for clarity) of a cooling system according to a possible embodiment;
- figure 2 is a schematic side view (with some parts removed for greater clarity) of the cooling system of figure 1;
- figure 3 is a schematic enlarged view (with some parts removed for greater clarity) of part of the cooling system of figure 2;
- figures 4 and 5 are schematic and perspective views of a possible embodiment of an insert of the cooling system of figures 1-3 from opposite (front-back) orientations; and
- figure 6 is a schematic diagram of the temperature trend of the system of figure 1 with and without the insert measured in different sections of the power module.

### PREFERRED EMBODIMENTS OF THE INVENTION

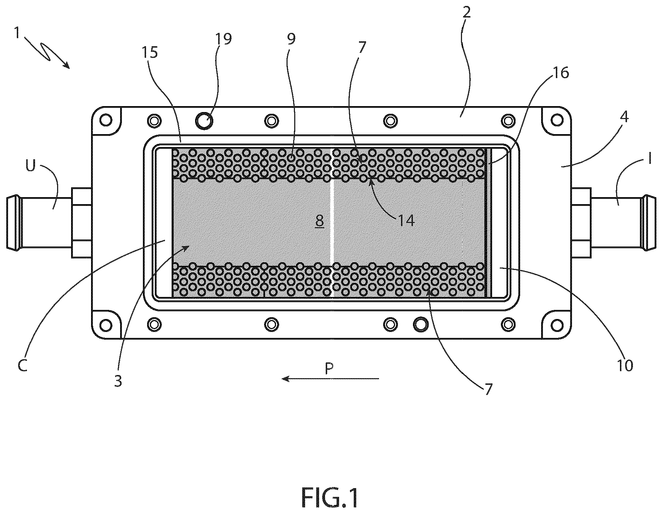

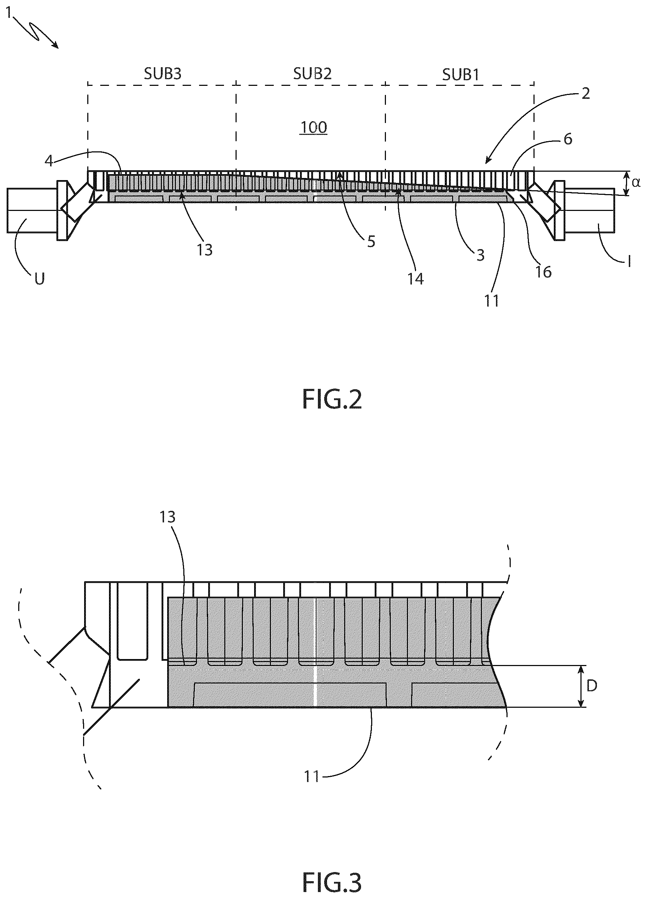

In figure 1, number 1 indicates, as a whole, a cooling system 1 for a power module 100 (schematically shown in figure 2), in particular for a preferably electric vehicle. In Figure 2, the power module 100 is shown as a set of a plurality of (in the non-limiting example, three) substrates SUB1-SUB3.

The cooling system 1 comprises (in particular, substantially consists of) a base plate 2 and an insert 3 (shown in grey in figures 1-3 to facilitate the distinction from the plate 2).

The base plate 2 comprises (in particular defines) a path P for a cooling fluid (such as, for example: water or air). The path P extends between an inlet I, where the cooling fluid enters the cooling system 1, and an outlet U, where the cooling fluid exits the cooling system 1.

The base plate 2 has a substantially parallelepiped-like shape and has two dimensions (i.e. a length, which is the dimension measured parallel to the fluid path P, and a width, which is the dimension measured transversely - in particular orthogonally - to the fluid path P) prevailing with respect to a third dimension (i.e. the thickness, which is the dimension measured transversely - in particular orthogonally - to the length and to the width). The base plate 2 is provided with two surfaces 4 and 5, which are parallel to and opposite one another. The power module 100 faces and is connected in the area of the surface 4, as described in detail below.

The base plate 2 is provided with a plurality of heat dissipation means 6 (not shown in figure 1), which project (in particular transversely or orthogonally) from the surface 5 of the base plate 2 in a direction transverse, in particular orthogonal, to the fluid path P. The dissipation means 6 are configured to dissipate (i.e. dispose of) the heat generated during the operation of the power module 100.

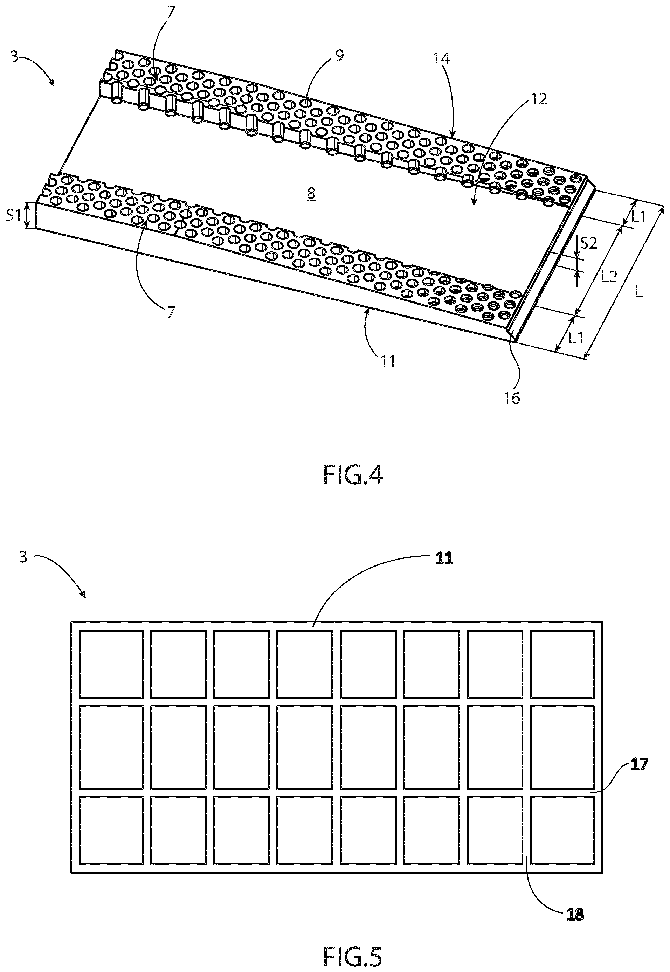

The insert 3, which is individually shown in figures 4 and 5 showing two opposite views (in particular, a front perspective view in figure 4 and a rear plan in figure 5), is arranged on the base plate 2 (as schematically shown in figures 1-3). In other words, the insert 3 is configured to impregnate the base plate 2. The insert 3 comprises (i.e. is divided into) two side sectors 7, which are parallel to and spaced apart from one another and laterally delimit a central channel 8, which is interposed between them (i.e. the two side sectors 7) and is configured to convey the cooling fluid.

In particular, the two side sectors 7 extend parallel to the fluid path P. The two side sectors 7 of the insert 3 are provided with a plurality of openings 9, each configured to be at least partially engaged by a respective dissipation means 6 of the base plate 2. In other words, the dissipation means 6 of the base plate 2 facing the side sectors 7 are at least partially arranged in the respective opening 9 facing them; whereas, the dissipation means 6 of the plate 2 facing the central channel 8 do not engage any opening 9 (because they are absent, as described in detail below).

In particular, as shown in the accompanying figures, the insert 3 is arranged inside a seat 10 (figure 1) obtained in the base plate 2. Hence, the seat 10 defines part of the cooling channel C of the system 1 together with the central channel 8 of the insert 3. In other words, the seat 10 defines the area of interaction between the cooling fluid and the insert 3.

Advantageously, the seat 10 has a dimension measured transversely - in particular orthogonally - to the fluid path P (i.e. parallel to the thickness of the plate 2) ranging from 6 to 12 mm, in particular ranging from 9 to 10 mm.

According to the accompanying figures, the openings 9 are exclusively obtained in the area of the two side sectors 7 of the insert 3. Therefore, the central channel 8 of the insert 3 is devoid of the openings 9. In other words, not all the dissipation means 6 of the plate 2 engage the openings 9. In fact, the sole dissipation means 6 facing the openings 9 of the side sectors 7 engage a respective opening 9. This is due to the fact that the two side sectors 7 have a thickness S1; whereas the central channel 8 has a thickness S2, which is smaller than the thickness S1. The thicknesses S1 and S2 are the dimensions that are measured transversely, i.e. orthogonally, to the fluid path P.

Advantageously, the openings 9 have a shape and a size that are complementary to the shape and the size of the dissipation means 6. In addition, in order to allow the openings 9 to be correctly engaged by the dissipation means 6, the openings 9 and the means 6 have a similar arrangement (i.e. distribution) in the plane.

Advantageously, according to the accompanying figures, the base plate 2 has heat dissipation means 6 comprising cylindrical pins with a circular cross section. Therefore, the openings 9 have a cross section with a circular shape. Preferably, the openings 9 all have the same transverse dimension (i.e. diameter) complementary to the dimension of the respective dissipation means 6.

According to a possible, non-limiting alternative, the openings 9 can have transverse dimensions (i.e. diameters) different from one another, but in any case complementary to the dimension of the respective dissipation means 6.

According to an alternative embodiment, which is not shown herein, the dispersion means 6 comprise sheet-like protrusions or cylindrical pins with an oval cross section. Therefore, in this case, the openings 9 have a suitable shape to accommodate, on the inside, the respective dispersion means 6. In other words, in this case, the openings 9 could be grooves (to accommodate the sheet-like protrusions) or openings with an oval cross section (to accommodate the cylindrical pins with an oval cross section).

According to an embodiment which is not shown herein, the openings 9 are through openings.

Alternatively, as shown in the accompanying drawings, the openings 9 of the insert 3 are blind openings and comprise a closed end 13, which is spaced apart from a surface 11 of the insert 3 itself by a distance D. The distance D ensures, based on the height of the channel C, that the surface 12 of the central channel 8 is in contact with the dissipation means 6 and facilitates the assembly of the insert 3 with the plate 2, in particular for the insertion of the means 6 into the respective openings 9. The distance D of all the ends 13 of the openings 9 is constant. In other words, all the openings 9 have the end 13 spaced from the surface 11 of the insert 3 by the same distance D. The surface 11 is opposite a side 12 of the insert 3 where the openings 9 are made.

Advantageously, the openings 9 are arranged on a plurality of rows (ordered succession of openings 9 arranged one after the other). According to the figures, the openings 9 of a row are staggered with respect to the openings 9 of the rows adjacent to it. According to a possible alternative, the openings 9 of a row are aligned with the openings 9 of the rows adjacent to it. For the purposes of this disclosure, the term "row" indicates the succession in a direction transverse - in particular orthogonal - to the path **P.**

Advantageously, though not in a limiting manner, according to the accompanying drawings, each side sector 7 has a width L1 (i.e. A dimension measured transversely, namely orthogonally, to the path P), which is smaller than one third of the overall width L of the insert 3. In other words, each side sector 7 has the width L1, which is smaller than 0.3 * L (with L identified as the overall width of the insert 3). On the other hand, the central channel 8 has a width L2 (i.e. A dimension measured transversely, in particular orthogonally, to the path P), which is greater than one third of the overall width L of the insert 3. In other words, the central channel 8 has the width L2, which is greater than 0.3 * L (with L identified as the overall width of the insert 3). In particular, the width L2 can range from 20 to 50 mm, preferably from 30 to 40 mm, more preferably from 34 to 37 mm, so as to obtain an excellent ratio between cooling and spatial dimensions.

According to a possible embodiment which is not shown herein, the thicknesses S1 and S2 are constant along the path P of the cooling fluid.

Alternatively, as shown in the accompanying drawings, each side sector 7 has at least one portion 14 having the thickness S1, which increases along the fluid path P, in particular in the direction from the inlet I to the outlet U. In particular, the portion 14 having the increasing thickness S1 is inclined at an inclination angle α smaller than 5°, ranging from 2 to 4°, preferably equal to 3°, relative to the surface 5 of the base plate 2 which it faces.

Preferably, the insert 3 is made of a plastic material, in particular a plastic material compatible with the operating temperatures (which typically range from 65°C to 100°C) and with the cooling fluid used. By way of non-limiting example, the insert 3 is made of a plastic material chosen from (a non-exhaustive and non-limiting list) one of the following technopolymers: polyparaphenylene sulfide (also known as PPS) or polybutylene terephthalate (also known as PBT).

Advantageously, the base plate 2 has a groove 15, which surrounds the entire seat 10 and is configured to house a gasket (not shown) configured to seal, when the cooling system 1 is coupled to the power module 100.

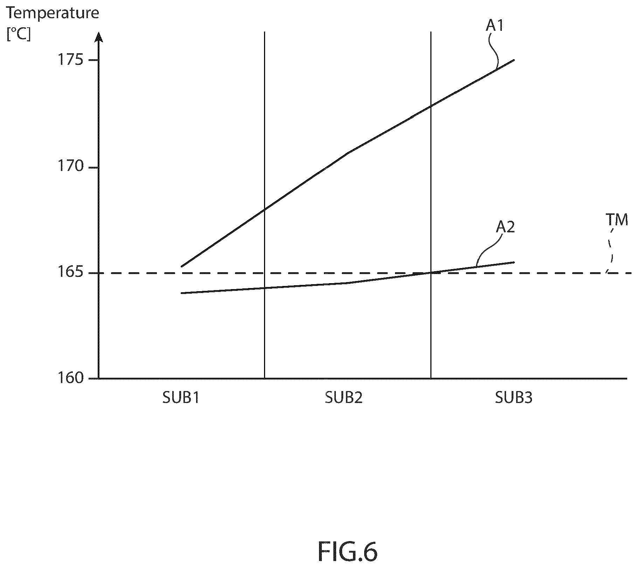

Laboratory tests have shown that excellent results are obtained by manufacturing the insert 3 with the openings 9 staggered relative to one another and provided with the portion 14 with an increasing thickness S1. To this regard, the diagram of figure 6 has been attached hereto in order to show a comparison of the trends A1 and A2 of the temperatures in the substrates SUB1-SUB3 of the power module 100 (for example, according to the hypothetical, i.e. fictitious, and non-limiting subdivision of the system 1 in the plane indicated in figure 2, which entails three substrates SUB1-SUB3). The section SUB1 is identified close to the inlet I, the section SUB3 is identified close to the outlet U of the cooling system 1 and the central section SUB2 is interposed between the sections SUB1 and SUB3.

In particular, line A1 indicates the trend of the temperatures for a power module 100 devoid of (i.e. without) the insert 3. Therefore, this hypothesis coincides with the state of the art. On the other hand, line A2 indicates the trend of the temperatures in a power module 100 with an insert 3 according to the invention, in particular provided with the portion 14 with an increasing thickness S1.

According to figures 1, 2 and 4, the insert 3 advantageously has, at a longitudinal end thereof facing the inlet I, a chamfer 16 configured to convey the cooling fluid into the insert 3 itself.

Advantageously, as shown in figures 2, 3 and 5, the insert 3 has, in the area of the surface 11, a plurality of longitudinal ribs 17 (i.e. which extend parallel to the path P) and a plurality of transverse ribs 18 (i.e. which extend transversely, in particular orthogonally, to the path P). The ribs 17 and 18 make it possible to further increase the exchange of heat with the surrounding environment.

According to a further aspect of the invention, there is also provided a power module 100 provided with the cooling system 1 described above.

In particular, the cooling system 1 is configured to be coupled to the power module 100 in the area of the surface 4 of the base plate 2 by means of a plurality of connection means (which are not shown).

Advantageously, the connection means engage suitable through openings 19 peripherally obtained in the base plate 2. The connection means can typically be centring pins and/or threaded connection means.

The cooling system 1 described above has a plurality of advantages. First of all, it improves the cooling of the power module 100 and balances the average temperature TM of the power module 100 in all sections SUB1-SUB3.

By manufacturing the insert 3 with a section with a thickness S1 increasing in the longitudinal direction of the cooling channel C (i.e. of the central channel 8 of the insert 3), the beneficial effect on the trend of the average temperatures TM is further increased, balancing the temperatures that can be obtained by the series cooling that is performed by the cooling system 1. Therefore, the heat map (i.e. the temperature distribution) in the power module 100 is substantially the same for each section SUB1-SUB3 of the power module 100. In other words, by manufacturing the insert 3 with the portion 14 with an increasing thickness S1, the temperature distribution is more even in the power module 100 (as shown by the diagram of figure 6). Furthermore, even in the section SUB3 closest to the outlet U (which is notoriously the least cooled and, therefore, the most critical) there is a good cooling, guaranteeing an approximate constancy (trend A2) of the average temperature TM along the entire cooling channel C.

The insert 3 also allows the cooling system 1 to be more scalable, so as to optimize its performance (with respect to the state of the art) for all the applicable power ranges.

In addition, the central channel 8 has the advantage of accelerating the cooling fluid while it flows along the cooling path P. Therefore, in the central channel 8, the flow of the cooling fluid is substantially turbulent. On the other hand, the openings 9 obtained in the area of the side sectors 7 allow these areas of the insert 3 to be involved in cooling as well, locally modifying the flow of the fluid (in particular, modifying the speed of the fluid) making it more laminar, so as to improve the cooling performance of the cooling system 1 itself. These improvements are due to the fact that each dissipation means 6 facing the side sectors 7 is lapped by the "slowed down" cooling fluid to a greater extent. Therefore, since the convection dissipation, namely the convective thermal resistance, depends on the amount of circumferential surface of the dissipation medium 6 lapped by the cooling fluid, by covering the dissipation means 6 with the insert 3, the fluid is slowed down and, hence, the circumferential surface of the dissipation means 6 lapped by the fluid is larger. Consequently, the convective contribution to the dissipation can be exploited to a greater extent.

### LIST OF REFERENCE NUMBERS

- 1: cooling system
- 2: base plate
- 3: insert
- 4: surface
- 5: surface
- 6: dissipation means
- 7: side sectors
- 8: central channel
- 9: openings
- 10: seat
- 11: surface
- 12: side
- 13: end
- 14: portion
- 15: groove
- 16: chamfer
- 17: longitudinal ribs
- 18: transverse ribs
- 19: openings
- 100: power module
- A1: temperature trend
- A2: trend
- C: cooling channel
- D: distance
- I: inlet
- L: width
- L1: width
- L2: width
- P: path
- S1: thickness
- S2: thickness
- SUB1: substrate
- SUB2: substrate
- SUB3: substrate
- TM: average temperature
- U: outlet

## Claims

1. A cooling system (1) for a power module (100) comprising:
a base plate (2) comprising a path (P) for a cooling fluid extending from an inlet (I), where the cooling fluid flows into the cooling system (1), and an outlet (U), where the cooling fluid flows out of the cooling system (1); the base plate (2) is provided with a plurality of heat dissipation means (6), which project from a surface (5) of the base plate (2) in a direction that is transverse, in particular orthogonal, to the path (P) of the cooling fluid; and
an insert (3) arranged on the base plate (2); wherein the insert (3) comprises two side sectors (7), which are parallel to and spaced apart from one another and laterally delimit a central channel (8), which is interposed between them and is configured to convey the cooling fluid; **characterised in that** the two side sectors (7) are provided with a plurality of openings (9), each configured to be at least partially engaged by a respective heat dissipation means (6) of the base plate (2).

2. The cooling system (1) according to claim 1, wherein the openings (9) are exclusively obtained in the area of the two side sectors (7).

3. The cooling system (1) according to claim 1 or 2, wherein each side sector (7) has a length (L), which is smaller than one third of the total width of the insert (3) .

4. The cooling system (1) according to any one of the preceding claims, wherein the two side sectors (7) have a first thickness (S1); whereas the central channel has a second thickness (S2), which is smaller than the first thickness (S1).

5. The cooling system (1) according to claim 4, wherein the first thickness (S1) and the second thickness (S2) are constant along the path (P) of the cooling fluid.

6. The cooling system (1) according to claim 4, wherein each side sector (7) has at least one portion (14) having the first thickness (S1), which increases along the path (P) of the cooling fluid, in particular in the direction from the inlet (I) to the outlet (U).

7. The cooling system (1) according to claim 6, wherein the portion (14) having the first increasing thickness (S1) is inclined at an inclination angle (α) smaller than 5°, in particular ranging from 2 to 4°, preferably equal to 3°, relative to the surface (5) of the based plate (2) which it faces.

8. The cooling system (1) according to any one of the preceding claims, wherein the openings (9) of the insert (3) are blind openings and comprise a closed end (13), which is spaced apart from a surface (11) of the insert (3) itself by a distance (D).

9. The cooling system (1) according to any one of the preceding claims, wherein the openings (9) are arranged on a plurality of rows; and the openings (9) of a row are staggered relative to the openings (9) of the rows adjacent to it.

10. The cooling system (1) according to any one of the claims from 1 to 8, wherein the openings (9) are arranged on a plurality of rows; and the openings (9) of a row are aligned with the openings (9) of the rows adjacent to it.

11. The cooling system (1) according to any one of the preceding claims, wherein the openings (9) have a cross section with a circular shape.

12. The cooling system (1) according to any one of the preceding claims, wherein the insert (3) is made of a plastic material.

13. A power module (100), in particular for a vehicle, comprising a cooling system (1) according to any one of the claims from 1 to 12.

## Patentansprüche

1. Kühlsystem (1) für ein Leistungsmodul (100), umfassend:
eine Grundplatte (2), umfassend einen Pfad (P) für ein Kühlfluid, der sich von einem Einlass (I), wo das Kühlfluid in das Kühlsystem (1) fließt, und einem Auslass (U) erstreckt, wo das Kühlfluid aus dem Kühlsystem (1) fließt; wobei die Grundplatte (2) mit einer Vielzahl von Wärmeableitungsmitteln (6) versehen ist, die von einer Oberfläche (5) der Grundplatte (2) in eine Richtung vorstehen, die quer, insbesondere orthogonal, zu dem Pfad (P) des Kühlfluids ist; und
einen Einsatz (3), der an der Grundplatte (2) angeordnet ist; wobei der Einsatz (3) zwei Seitensektoren (7) umfasst, die parallel zueinander und beabstandet voneinander sind, und einen zentralen Kanal (8) lateral begrenzen, der zwischen ihnen eingeschoben ist und konfiguriert ist, um das Kühlfluid zu leiten; **dadurch gekennzeichnet, dass** die zwei Seitensektoren (7) mit einer Vielzahl von Öffnungen (9) versehen sind, wobei jede konfiguriert ist, um mindestens teilweise durch ein jeweiliges Wärmeableitungsmittel (6) der Grundplatte (2) in Eingriff genommen zu werden.

2. Kühlsystem (1) nach Anspruch 1, wobei die Öffnungen (9) ausschließlich in dem Bereich der zwei Seitensektoren (7) erhalten werden.

3. Kühlsystem (1) nach Anspruch 1 oder 2, wobei jeder Seitensektor (7) eine Länge (L) aufweist, die kleiner als ein Drittel der Gesamtbreite des Einsatzes (3) ist.

4. Kühlsystem (1) nach einem der vorstehenden Ansprüche, wobei die zwei Seitensektoren (7) eine erste Dicke (S1) aufweisen; wohingegen der zentrale Kanal eine zweite Dicke (S2) aufweist, die kleiner als die erste Dicke (S1) ist.

5. Kühlsystem (1) nach Anspruch 4, wobei die erste Dicke (S1) und die zweite Dicke (S2) entlang des Pfads (P) des Kühlfluids konstant sind.

6. Kühlsystem (1) nach Anspruch 4, wobei jeder Seitensektor (7) mindestens einen Abschnitt (14) aufweist, der die erste Dicke (S1) aufweist, die entlang des Pfads (P) des Kühlfluids, insbesondere in der Richtung von dem Einlass (I) zu dem Auslass (U), zunimmt.

7. Kühlsystem (1) nach Anspruch 6, wobei der Abschnitt (14), der die erste zunehmende Dicke (S1) aufweist, in einem Neigungswinkel (α), der kleiner als 5°, insbesondere von 2 bis 4° reicht, vorzugsweise gleich 3° ist, relativ zu der Oberfläche (5) der Grundplatte (2), der er zugewandt ist, geneigt ist.

8. Kühlsystem (1) nach einem der vorstehenden Ansprüche, wobei die Öffnungen (9) des Einsatzes (3) Sacköffnungen sind und ein geschlossenes Ende (13) umfassen, das selbst von einer Oberfläche (11) des Einsatzes (3) um eine Distanz (D) entfernt beabstandet ist.

9. Kühlsystem (1) nach einem der vorstehenden Ansprüche, wobei die Öffnungen (9) in einer Vielzahl von Reihen angeordnet sind; und die Öffnungen (9) einer Reihe relativ zu den Öffnungen (9) der daran angrenzenden Reihen versetzt sind.

10. Kühlsystem (1) nach einem der Ansprüche von 1 bis 8, wobei die Öffnungen (9) in einer Vielzahl von Reihen angeordnet sind; und die Öffnungen (9) einer Reihe mit den Öffnungen (9) der daran angrenzenden Reihen ausgerichtet sind.

11. Kühlsystem (1) nach einem der vorstehenden Ansprüche, wobei die Öffnungen (9) einen Querschnitt mit einer Kreisform aufweisen.

12. Kühlsystem (1) nach einem der vorstehenden Ansprüche, wobei der Einsatz (3) aus einem Kunststoffmaterial hergestellt ist.

13. Leistungsmodul (100), insbesondere für ein Fahrzeug, umfassend ein Kühlsystem (1) nach einem der Ansprüche von 1 bis 12.

## Revendications

1. Système de refroidissement (1) pour un module de puissance (100) comprenant :
une plaque de base (2) comprenant un chemin (P) pour un fluide de refroidissement s'étendant d'une entrée (I), où le fluide de refroidissement s'écoule dans le système de refroidissement (1), à une sortie (U), où le fluide de refroidissement s'écoule hors du système de refroidissement (1) ; la plaque de base (2) est pourvue d'une pluralité de moyens de dissipation de la chaleur (6), qui font saillie à partir d'une surface (5) de la plaque de base (2) dans une direction qui est transversale, en particulier orthogonale, à la trajectoire (P) du fluide de refroidissement ; et
un insert (3) disposé sur la plaque de base (2) ; dans lequel l'insert (3) comprend deux secteurs latéraux (7), parallèles et espacés l'un de l'autre, qui délimitent latéralement un canal central (8), interposé entre eux et configuré pour acheminer le fluide de refroidissement ; **caractérisé en ce que** les deux secteurs latéraux (7) sont pourvus d'une pluralité d'ouvertures (9), chacune configurée pour être au moins partiellement engagée par un moyen de dissipation thermique respectif (6) de la plaque de base (2).

2. Système de refroidissement (1) selon la revendication 1, dans lequel les ouvertures (9) se trouvent exclusivement dans la zone des deux secteurs latéraux (7).

3. Système de refroidissement (1) selon la revendication 1 ou 2, dans lequel chaque secteur latéral (7) a une longueur (L) inférieure à un tiers de la largeur totale de l'insert (3).

4. Système de refroidissement (1) selon l'une quelconque des revendications précédentes, dans lequel les deux secteurs latéraux (7) ont une première épaisseur (S1) ; tandis que le canal central a une seconde épaisseur (S2), qui est plus petite que la première épaisseur (S1).

5. Système de refroidissement (1) selon la revendication 4, dans lequel la première épaisseur (S1) et la seconde épaisseur (S2) sont constantes le long du trajet (P) du fluide de refroidissement.

6. Système de refroidissement (1) selon la revendication 4, dans lequel chaque secteur latéral (7) a au moins une partie (14) ayant la première épaisseur (S1), qui augmente le long du trajet (P) du fluide de refroidissement, en particulier dans la direction de l'entrée (I) à la sortie (U).

7. Système de refroidissement (1) selon la revendication 6, dans lequel la partie (14) ayant la première épaisseur croissante (S1) est inclinée à un angle d'inclinaison (α) inférieur à 5°, en particulier allant de 2 à 4°, de préférence égal à 3°, par rapport à la surface (5) de la plaque de base (2) à laquelle elle fait face.

8. Système de refroidissement (1) selon l'une quelconque des revendications précédentes, dans lequel les ouvertures (9) de l'insert (3) sont des ouvertures aveugles et comprennent une extrémité fermée (13), qui est séparée d'une surface (11) de l'insert (3) lui-même par une distance (D).

9. Système de refroidissement (1) selon l'une quelconque des revendications précédentes, dans lequel les ouvertures (9) sont disposées sur plusieurs rangées ; et les ouvertures (9) d'une rangée sont décalées par rapport aux ouvertures (9) des rangées adjacentes.

10. Système de refroidissement (1) selon l'une quelconque des revendications 1 à 8, dans lequel les ouvertures (9) sont disposées sur plusieurs rangées ; et les ouvertures (9) d'une rangée sont alignées avec les ouvertures (9) des rangées adjacentes.

11. Système de refroidissement (1) selon l'une quelconque des revendications précédentes, dans lequel les ouvertures (9) ont une section transversale de forme circulaire.

12. Système de refroidissement (1) selon l'une quelconque des revendications précédentes, dans lequel l'insert (3) est en matière plastique.

13. Module de puissance (100), en particulier pour un véhicule, comprenant un système de refroidissement (1) selon l'une quelconque des revendications 1 à 12.
